# EUROPÄISCHE PATENTSCHRIFT

(11) **EP 0 560 191 B1**
(45) Veröffentlichungstag und Bekanntmachung des Hinweises auf die Patenterteilung: **10.06.1998**
(21) Anmeldenummer: 93103371.6
(22) Anmeldetag: 03.03.1993
(51) Int. Cl.: G06F 1/18, H05K 5/00, A62C 3/00

(54) **Sicherheitseinrichtung für EDV-Anlagen**
Security device for data processing apparatus
Dispositif de sécurité pour appareil de traitement de données

(30) Priorität: 10.03.1992 DE 4207509; 27.04.1992 DE 4213758
(43) Veröffentlichungstag der Anmeldung: 15.09.1993
(73) Patentinhaber: OTTO LAMPERTZ, FABRIKEN FÜR ORGANISATIONSMITTEL UND EDV-ZUBEHÖR GMBH & CO. KG, 57518 Betzdorf (DE)
(72) Erfinder: Frase, Hans-Jürgen, W-5241 Niederdreisbach (DE)
(74) Vertreter: Pürckhauer, Rolf, Dipl.-Ing.

(56) Entgegenhaltungen:
- WO-A-86/02568
- FR-A- 2 551 619
- US-A- 4 727 934
- US-A- 4 847 602

## Beschreibung

Die Erfindung bezieht sich auf eine Sicherheitseinrichtung für EDV-Anlagen nach dem Oberbegriff des Patentanspruchs 1.

Elektronische Rechner werden häufig in einer nicht EDV-gerechten Umgebung aufgestellt, um eine Datenverarbeitung vor Ort durchzuführen. Dies geschieht in kommerziellen Bereichen wie Personalwesen, Buchhaltung, Bankwesen, Einkauf und Verkauf und auch in den technischen Bereichen wie Forschung und Entwicklung, Konstruktion, Arbeitsvorbereitung bis hin zur technischen Qualitätskontrolle und in den Fertigungsbereichen. Dort stehen Rechner ohne Schutz gegen Feuer-, Gas- und Rauchentwicklung, Feuchtigkeit und Wassereinbruch sowie den Zugriff von unberechtigten und unwissenden Personen. Ein durch äußere Einflüsse bedingter Ausfall der Rechner kann zu einem hohen Störpotential in dem angeschlossenen Bereich mit entsprechend großen Folgekosten führen.

In US-A-4 847 602, von der die Erfindung ausgeht, ist ein Computer-Terminal beschrieben, das gegen Explosion geschützt ist.

Eine ähnliche Feuerschutzeinrichtung für elektronische Einrichtungen zeigt WO 86/02568.

In FR-A-2 551 619 ist eine gegen Feuer geschützte EDV-Speichereinheit beschrieben.

Der Erfindung liegt die Aufgabe zugrunde, eine Sicherheitseinrichtung zu entwickeln, die vor allem kleinere und mittlere elektronische Rechner gegen äußere Störfaktoren wie Feuer, Feuchtigkeit, Wassereinbruch, Brandgase, Magnetfelder und Zugriff durch unberechtigte Personen in hohem Maße schützt und dabei stets einen störungsfreien Betrieb der Rechner ermöglicht.

Diese Aufgabe ist erfindungsgemäß gelöst durch die Kennzeichnungsmerkmale des Patentanspruches 1.

Die Unteransprüche sind auf zweckmäßige Weiterbildungen der Erfindung gerichtet.

Der erfindungsgemäße Container gewährleistet ein höchstes Maß an Sicherheit für Rechner gegen Störfaktoren wie Feuer, Temperatureinflüsse, Feuchtigkeit, Wassereinbruch, Brandgase, Magnetfelder und unerwünschten Zugriff und ist mit Einrichtungen wie einer Klimaanlage und einer unterbrechungsfreien Stromversorgung zur Durchführung eines störungsfreien Betriebs der Rechner ausgerüstet, so daß der Rechner eine geraume Zeitdauer auch dann noch funktionsfähig ist, wenn einer oder mehrere Störfaktoren auftreten. Eine Montagewand mit den für den Betrieb eines Rechners erforderlichen Einrichtungen sowie je nach Containergröße eine Tür oder zwei Türen erleichtern durch ihre Demontierbarkeit von dem mehrwandigen Containergehäuse des Containers den Transport und die Aufstellung desselben. Durch die Anbringung sämtlicher Zusatzaggregate des Rechners an der Montagewand im Betrieb des Herstellers wird die betriebsbereite Aufstellung des Containers beim Betreiber eines Rechners nach einer erforderlichen Demontage der Montagewand, z.B. für den Transport des Containers durch die Tür eines Aufstellungsraumes, wesentlich erleichtert. Das Riegelwerk der Tür bzw. Türen des Containers mit Verriegelungsbolzen, die die Tür nach allen vier Seiten sichern, sowie die Außen- und Innenverschraubung der Montagewand mit dem Containergehäuse gestalten den Container in hohem Maße einbruchsicher.

Das zwischen Containergehäuse und Montagewand angeordnete Erweiterungsbauteil vergrößert die innere Tiefe des Containers und ermöglicht somit einerseits die Anpassung des Containers an die jeweiligen Rechnergrößen und andererseits eine tiefenparallele Unterbringung der Rechner, um die Bedienung und Handhabung von Datenträgern, die in die Rechner eingeführt bzw. aus diesen entnommen werden, zu erleichtern.

Die Erfindung ist nachstehend anhand von in verschiedenen Zeichnungsfiguren schematisch dargestellten Ausführungsbeispielen näher erläutert. Es zeigen
- Fig. 1: eine perspektivische Darstellung einer ersten Ausführungsform des erfindungsgemäßen Containers für einen Rechner,
- Fig. 2: eine Sprengdarstellung der einzelnen Bauteile des Containers nach Fig. 1,
- Fig. 3: eine Einzelheit nach Ausschnitt III der Fig. 2,
- Fig. 4: eine Einzelheit nach Ausschnitt IV der Fig. 2,
- Fig. 5: einen Vertikalschnitt durch den Container nach Linie V-V der Fig. 1,
- Fig. 6: einen Horizontalschnitt durch den Container nach Linie VI-VI der Fig. 1, jeweils in vergrößerter Darstellung,
- Fig. 7: eine Einzelheit nach Ausschnitt VII der Fig. 5 und
- Fig. 8: eine Einzelheit nach Ausschnitt VIII der Fig. 6,
- Fig. 9: eine Sprengdarstellung der einzelnen Bauteile einer zweiten Ausführungsform des Containers,

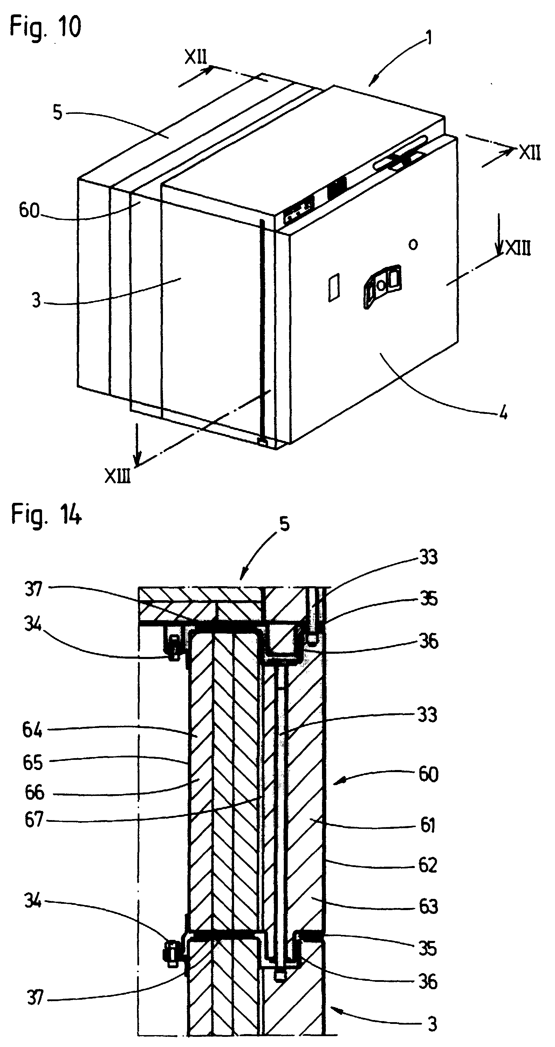

- Fig. 10: eine perspektivische Darstellung der ersten Ausführungsform des erfindungsgemäßen Containers mit Erweiterungsbauteil,
- Fig. 11: eine Sprengdarstellung der einzelnen Bauteile des Containers nach Fig. 10,
- Fig. 12: einen Vertikalschnitt durch den Container nach Linie XII-XII der Fig. 10,
- Fig. 13: einen Horizontalschnitt durch den Container nach Linie XIII-XIII der Fig. 10, jeweils in vergrößerter Darstellung und
- Fig. 14: eine Einzelheit nach Ausschnitt XIV der Fig. 13.

Bei den beschriebenen Ausführungsbeispielen sind gleiche oder ähnliche Bauteile durch gleiche Bezugszeichen gekennzeichnet.

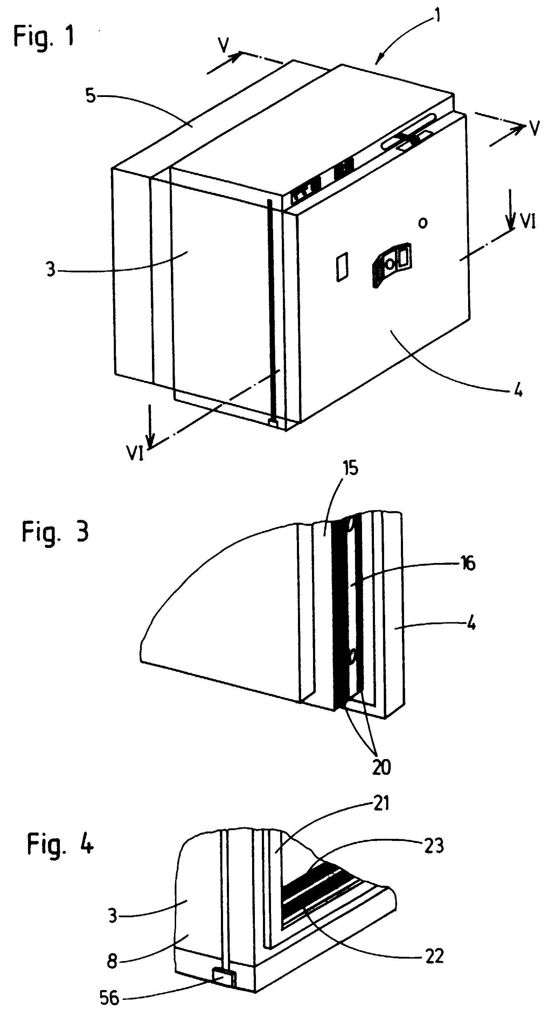

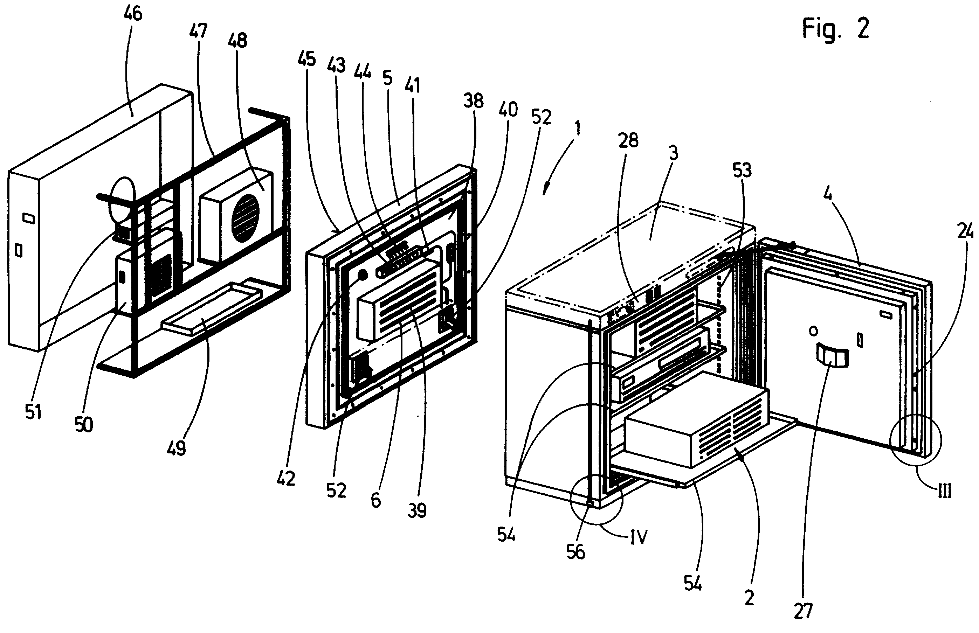

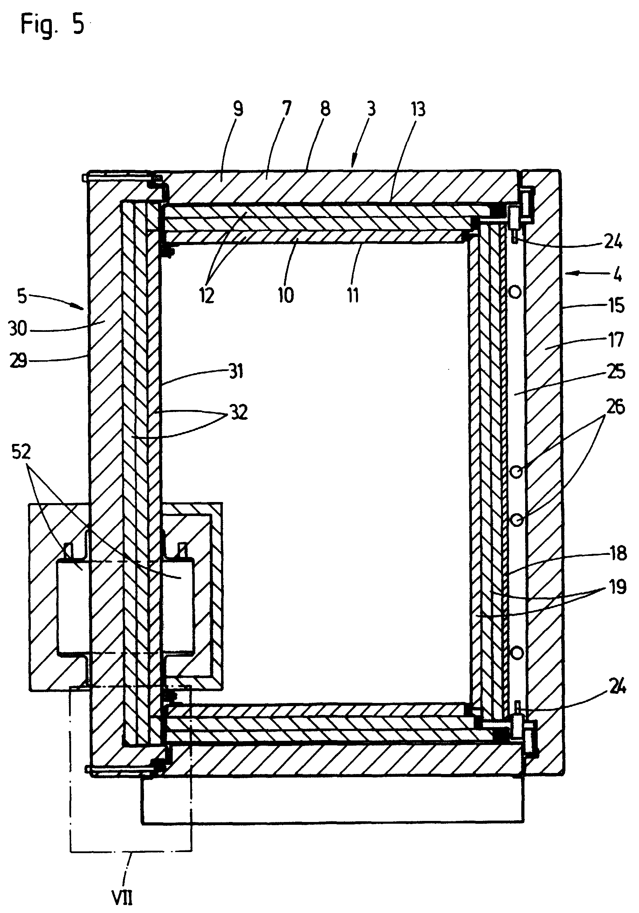

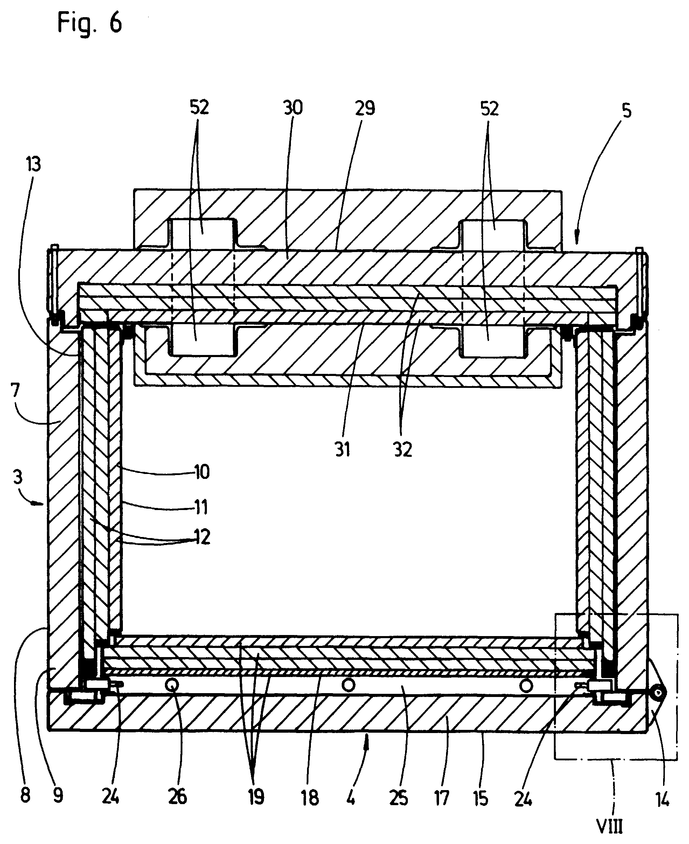

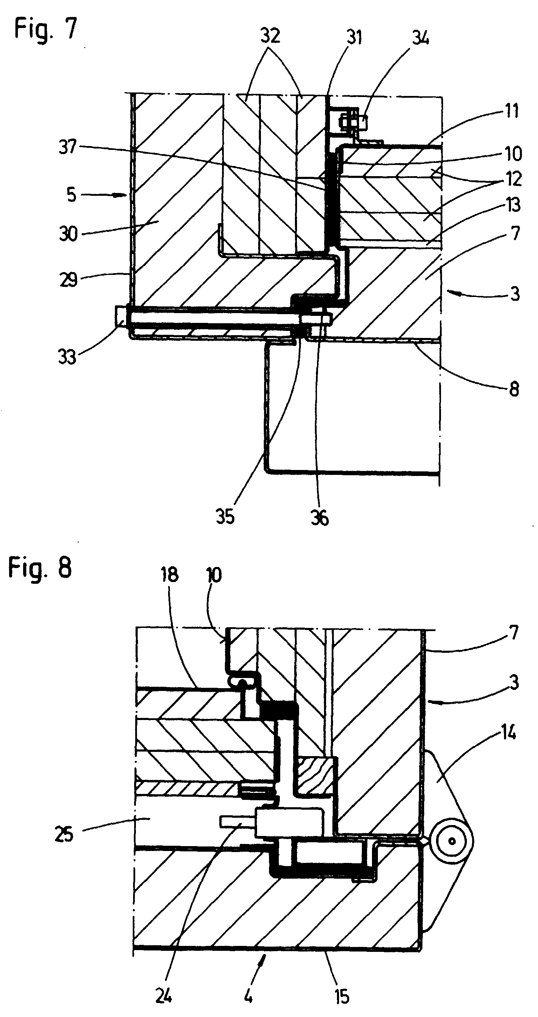

Der gegen äußere Störfaktoren wie Feuer, Feuchtigkeit, Wassereinbruch, Brandgase und Magnetfelder geschützte und gegen Einbruch gesicherte Container 1 nach den Fign. 1 bis 8 dient zur gesicherten Aufnahme von kleineren elektronischen Rechnern 2 mit deren einzelnen Einheiten und zum Betrieb der Rechner.

Der Container 1 besteht aus einem mehrwandigen, als Faradayscher Käfig ausgebildeten Containergehäuse 3 mit einer Tür 4 und einer Montagewand 5 zur Anbringung verschiedener, nachfolgend beschriebener Betriebseinrichtungen für den Rechner 2 und ist mit einer Klimaanlage 6 ausgerüstet. Tür 4 und Montagewand 5 des Containers 1 sind zur Erleichterung des Transportes vom Herstellerwerk zum Abnehmer und zum Einbringen durch eine handelsübliche Tür in den Aufstellungsraum von dem Containergehäuse 3 demontierbar.

Das Containergehäuse 3 ist durch ein Außengehäuse 7 mit einem Außenmantel 8 aus Stahlblech und einem Schichtaufbau 9 aus einem Wärmedämmaterial wie Beton und durch ein Innengehäuse 10 mit einem Innenmantel 11 aus Stahlblech und zwei Schichten 12 aus wärmeabsorbierenden Materialien wie Phosphat und Polyurethanharz gebildet. Außen- 7 und Innengehäuse 10 des Containergehäuses 3 sind durch einen Zwischenraum 13 getrennt.

Die Containertür 4, die mittels kugelgelagerter Schwerlastbänder 14 an dem Containergehäuse 3 anscharniert ist, besteht aus einem Außengehäuse 15 aus Stahlblech mit umlaufenden Feuer- und Dichtigkeitsfalzen 16 sowie einem Schichtaufbau 17 aus einem Wärmedämmaterial wie Beton und aus einem als Stahlblechkassette ausgebildeten Innengehäuse 18 mit drei Schichten 19 aus wärmeabsorbierenden Materialien wie Rigips, Polyurethanharz und Phosphat.

In der Türfalz 16 der Containertür 4 sind umlaufende Dichtungen 20 eingelegt, die bei 100 bis 150° C den erforderlichen Freiraum zwischen Tür 4 und der Türzarge 21 im Containergehäuse 3 zuschäumen.

Flexible, umlaufende Hochtemperaturdichtungen 22 in der Zarge 21 der Containertür 4, die Temperaturen bis zu 1200° C standhalten und sich den Unebenheiten in der Metalloberfläche anpassen, verhindern das Eindringen der Hitze über den Zargenbereich in den Container 1. Umlaufende Wasser- und Gasdichtungen 23 aus Gummi in der Türzarge 21 stellen sicher, daß keine Feuchtigkeit, kein Löschwasser und keine aggressiven Brandgase ins Containerinnere gelangen können.

Verriegelungsbolzen 24 eines in den Zwischenraum 25 zwischen Außen- 15 und Innengehäuse 18 der Containertür 4 eingebauten Riegelwerkes 26 sichern die Containertür 4 nach allen vier Seiten. Die Containertür 4 ist mit einem Sicherheitsschloß 27 und einer automatischen Schließ- und Öffnungsanlage 28 ausgestattet.

Die demontierbare Montagewand 5 des Containers 1 weist ein Außengehäuse 29 aus Stahlblech mit einem Schichtaufbau 30 aus einem Wärmedämmaterial wie Beton und ein als Stahlblechwanne ausgebildetes Innengehäuse 31 mit einem Schichtaufbau 32 aus wärmeabsorbierenden Materialien wie Polyurethanharz und Phosphat auf. Die Montagewand 5 ist durch eine Außen- 33 und eine Innenverschraubung 34 mit dem Containergehäuse 3 verbunden und durch feuersichere Hochtemperaturdichtungen 35 und bei erhöhten Temperaturen expandierende Dichtungen 36 sowie gas- und wasserdichte Dichtungen 37 aus Gummi oder dgl. gegenüber dem Containergehäuse 3 bzw. einem Erweiterungsbauteil 60 abgedichtet.

Auf der Innenseite 38 der Montagewand 5 sind ein Lüfter 39 und der Bedienungsteil 40 der Klimaanlage 6, ein Temperaturmeßfühler 41, ein Rauch- und Temperaturmelder 42, eine Steckerleiste 43 und eine Wandleuchte 44 und auf der Außenseite 45 der Montagewand 5 ein durch einen abnehmbaren Schutzkasten 46 aus Lochblech abgedecktes Aufnahmegestell 47 für den Kondensator 48 der Klimaanlage 6, eine Kondenswasserwanne 49 zum Auffangen des bei der Luftkühlung entstehenden, aus dem Container 1 abgeleiteten Kondenswassers, ein Aggregat 50 für die unterbrechungsfreie Stromversorgung des Rechners 2 und eine Temperaturmeßanzeige 51 angebracht.

Der Temperaturmeßfühler 41 auf der Innenseite 38 der Montagewand 5 ist mit einer Grenzwertüberwachung verbunden, die bei Unter- bzw. Überschreitungen der eingestellten Temperaturwerte im Containerinnenraum einen optischen und akustischen Alarm auslöst.

Die Klimaanlage 6 verhindert das Entstehen von Stauwärme beim Betrieb des Rechners 2 und regelt die für die Funktion des Rechners 2 erforderliche Temperatur und Feuchtigkeit im Containerinnenraum.

Die Einführung der für den Betrieb des Rechners 2 erforderlichen Energie- und Datenkabel sowie der Kältemittelleitungen der Klimaanlage 6 in den Containerinnenraum erfolgt über auf der Innen- 38 und Außenseite 45 der Montagewand 5 angeordnete feuersichere, wasserdichte und druckbeständige Massenspeicher-Kabelschotts 52.

Auf Staffelleisten 53 im Containergehäuse 3 aufliegende Auszugsplatten 54 dienen zur Aufnahme der Einheiten des Rechners 2.

Die Klimaanlage 6 ist als Sicherheitsanlage ausgeführt und besteht aus zwei selbständigen, zusammenwirkenden Anlagenteilen.

Bei dem vorbeschriebenen Container 1 für kleinere Rechner 2 mit einer Tür 4 für die Bedienung des Rechners und für die Durchführung von Wartungs- und Reparaturarbeiten bildet die demontierbare Montagewand 5 die Rückwand des Containers 1.

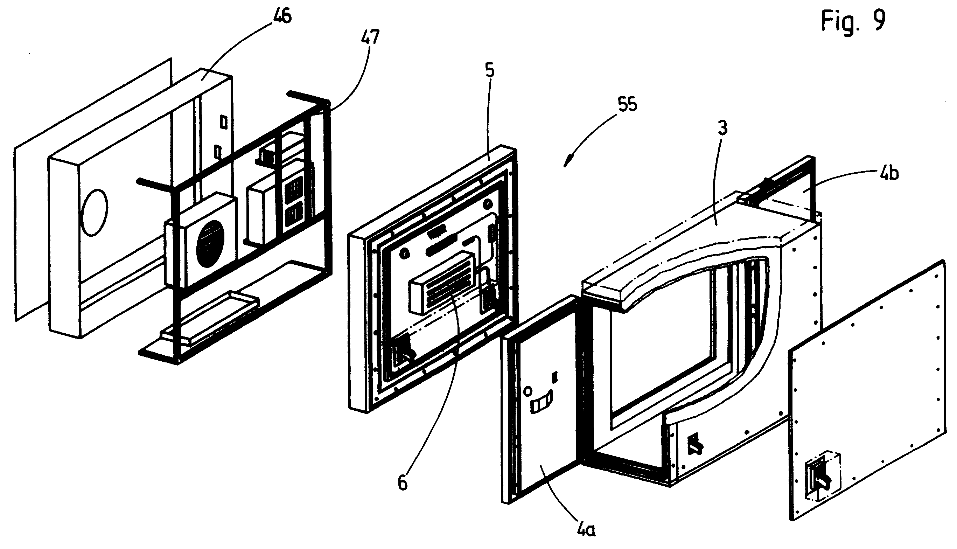

Der Container 55 nach Fig. 9 für mittlere Rechner, wie Bereichs- und Netzwerkrechner, weist eine Vordertür 4a für die Bedienung des Rechners 2 und eine Hintertür 4b für die Durchführung von Wartungs- und Reparaturarbeiten und eine als Montagewand 5 ausgebildete Seitenwand auf. Der Container 55 nach Fig. 9 ist im wesentlichen in gleicher Weise wie der Container 1 nach den Fign. 1 bis 8 ausgebildet.

Die Container 1, 55 können mit elektronischen Überwachungseinrichtungen, wie Alarmdrahtmatten als Außenhautüberwachung und/oder Körperschallmeldern und automatischen Löschanlagen, ausgerüstet werden. Schließlich kann am Außenmantel 8 des Containergehäuses 3 ein Wassermelder 56 angebracht werden.

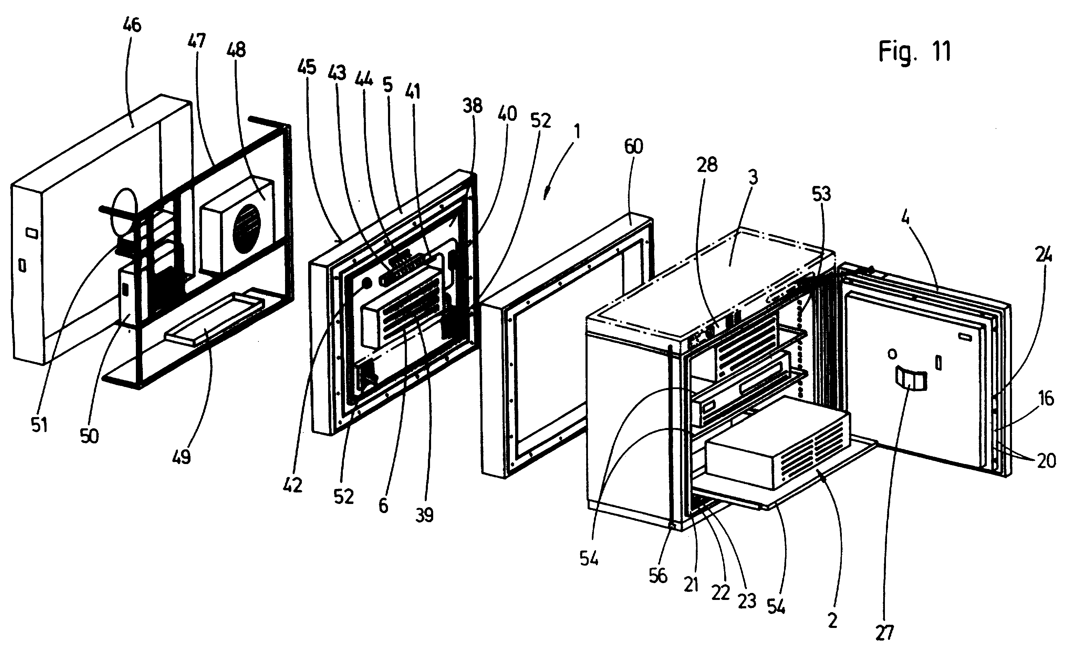

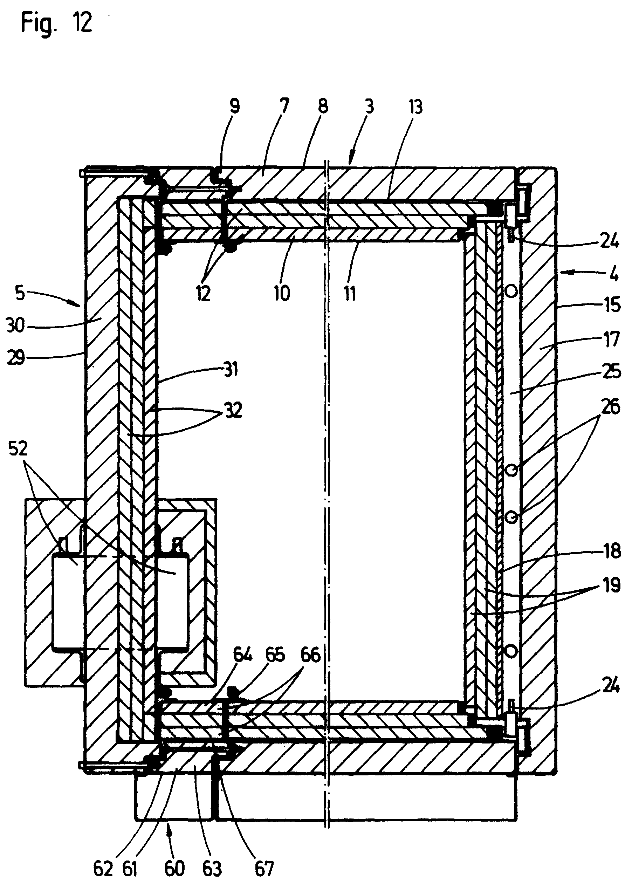

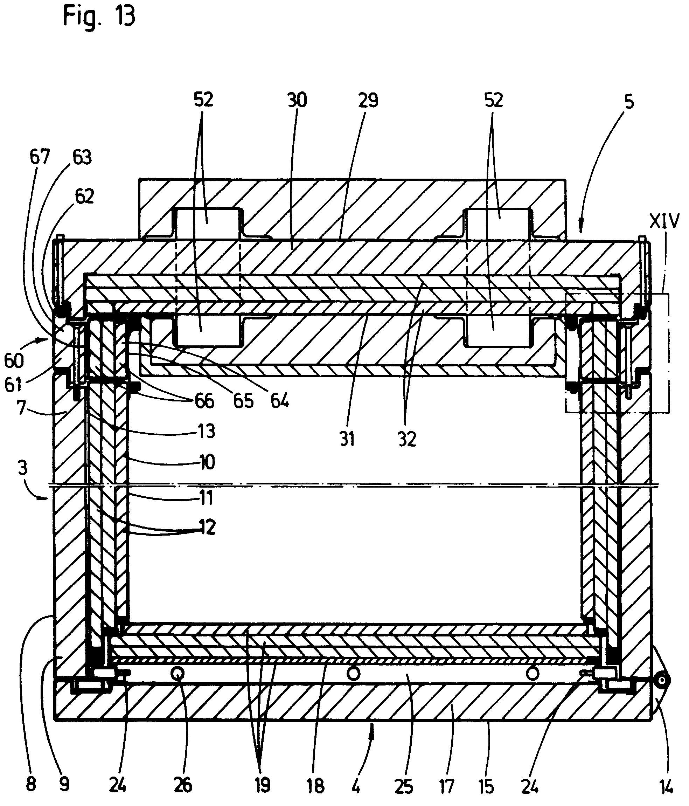

Der Container 1 nach den Fign. 11 bis 15 ist zur Vergrößerung des Innenraumes desselben mit dem Erweiterungsbauteil 60 ausgestattet. Das demontierbare Erweiterungsbauteil 60 ist durch ein Außengehäuse 61 mit einem Außenmantel 62 aus Stahlblech und einem Schichtaufbau 63 aus einem Wärmedämmaterial wie Beton und durch ein Innengehäuse 64 mit einem Innenmantel 65 aus Stahlblech und zwei Schichten 66 aus wärmeabsorbierenden Materialien wie Phosphat und Polyurethanharz gebildet. Außen- 61 und Innengehäuse 64 des Erweiterungsbauteils 60 sind durch einen Zwischenraum 67 getrennt. Das Erweiterungsbauteil 60 ist durch die Außen- 33 und die Innenverschraubung 34 mit dem Containergehäuse 3 verbunden und durch die feuersicheren Hochtemperaturdichtungen 35 und bei erhöhten Temperaturen expandierenden Dichtungen 36 sowie gas- und wasserdichten Dichtungen 37 aus Gummi oder dgl. gegenüber dem Containergehäuse 3 abgedichtet.

## Patentansprüche

1. Sicherheitseinrichtung für EDV-Anlagen mit einem gegen äußere Störfaktoren wie Feuer, Feuchtigkeit, Wassereinbruch, Brandgase und Magnetfelder geschützten, gegen Einbruch gesicherten Container (1,55) zur Aufanhme und für den Betrieb eines elektronischen Rechners (2) und mit einer Klimaanlage (6), **dadurch gekennzeichnet**, daß der Container (1,55) aus einem mehrwandigen, als Faradayscher Käfig ausgebildeten Containergehäuse (3) mit mindestens einer Tür (4) und einer Montagewand (5) zur Anbringung von Betriebseinrichtungen für den Rechner (2) besteht, wobei Tür (4) und Montagewand (5) zu Transport- und Aufstellungszwecken vom Containergehäuse (3) des Containers (1,55) abnehmbar sind, und daß die für den Betrieb des Rechners (2) erforderlichen Energie- und Datenkabel sowie die Kältemittelleitungen der Klimaanlage (6) über auf der Innenseite (38) und Außenseite (45) der Montagewand (5) angeordnete feuersichere, waaserdichte und druckbeständige Massenspeicher-Kabelschotts (52) in den Containerinnenraum eingeführt sind.

2. Sicherheitseinrichtung nach Anspruch 1, dadurch gekennzeichnet, daß das Containergehäuse (3) durch ein Außengehäuse (7) mit einem Außenmantel (8) aus Stahlblech und einem Schichtaufbau (9) aus einem Wärmedämmaterial oder verschiedenen Dämmaterialien und durch ein Innengehäuse (10) mit einem Innenmantel (11) aus Stahlblech und einer oder mehreren Schichten (12) wärmeabsorbierendem Material gebildet ist.

3. Sicherheitseinrichtung nach Anspruch 2, dadurch gekennzeichnet, daß Außen- (7) und Innengehäuse (10) des Containergehäuses (3) durch einen Zwischenraum (13) getrennt sind.

4. Sicherheitseinrichtung nach einem der Ansprüche 1 bis 3, dadurch gekennzeichnet, daß die bzw. jede Tür (4) des Containers (1, 55) aus einem Außengehäuse (15) aus Stahlblech mit umlaufenden Feuer- und Dichtigkeitsfalzen (16) sowie einem Schichtaufbau (17) aus einem oder verschiedenen Wärmedämmaterialien und aus einem als Stahlblechkassette ausgebildeten Innengehäuse (18) mit einer oder mehreren Schichten (19) aus wärmeabsorbierendem Material besteht.

5. Sicherheitseinrichtung nach Anspruch 4, gekennzeichnet durch umlaufende, bei erhöhten Temperaturen expandierende Dichtungen (20) im Türfalz (16) und eine umlaufende Wasserund Gasdichtung (23) sowie eine umlaufende Hochtemperaturdichtung (22) in der Türzarge (21) der Tür (4).

6. Sicherheitseinrichtung nach Anspruch 4 und 5, gekennzeichnet durch ein Riegelwerk (26) mit die Tür (4) auf allen vier Seiten sichernden Verriegelungsbolzen (24).

7. Sicherheitseinrichtung nach einem der Ansprüche 1 bis 6, dadurch gekennzeichnet, daß die abnehmbare Montagewand (5) des Containers (1, 55) ein Außengehäuse (29) aus Stahlblech mit einem Schichtaufbau (30) aus einem Wärmedämmaterial oder verschiedenen Wärmedämmaterialien und ein als Stahlblechwanne ausgebildetes Innengehäuse (31) mit einem Schichtaufbau (32) aus wärmeabsorbierendem Material aufweist und daß die Montagewand (5) durch eine Außen- (33) und eine Innenverschraubung (34) mit dem Containergehäuse (3) verbunden ist, wobei die Montagewand (5) durch feuersichere Hochtemperaturdichtungen (35) und bei erhöhten Temperaturen expandierende Dichtungen (36) sowie gas- und wasserdichte Dichtungen (37), z.B. aus Gummi, gegenüber dem Containergehäuse (3) abgedichtet ist.

8. Sicherheitseinrichtung nach Anspruch 7, dadurch gekennzeichnet, daß auf der Innenseite (38) der Montagewand (5) Lüfter (39) und Bedienungsteil (40) der Klimaanlage (6), ein Temperaturmeßfühler (41), ein Rauch- und Temperaturmelder (42), eine Steckerleiste (43) und eine Wandleuchte (44) und auf der Außenseite (45) der Montagewand (5) ein durch einen abnehmbaren Schutzkasten (46) abgedecktes Aufnahmegestell (47) für den Kondensator (48) der Klimaanlage (6), eine Kondenswasserwanne (49), ein Aggregat (59) für die unterbrechungsfreie Stromversorgung des Rechners (2) und eine Temperaturaußenanzeige (51) angebracht sind.

9. Sicherheitseinrichtung nach einem der Ansprüche 1 bis 8, gekennzeichnet durch in den Container (1, 55) eingebaute Auszugsplatten (54) zur Aufnahme der Einheiten des Rechners (2).

10. Sicherheitseinrichtung nach einem der Ansprüche 1 bis 9, dadurch gekennzeichnet, daß die Klimaanlage (6) als Sicherheitsanlage ausgeführt ist und aus zwei selbständigen, zusammenwirkenden Anlagenteilen besteht.

11. Sicherheitseinrichtung nach einem der Ansprüche 1 bis 10, dadurch gekennzeichnet, daß die Montagewand (5) die Rückwand des Containers (1) bildet.

12. Sicherheitseinrichtung nach einem der Ansprüche 1 bis 10, dadurch gekennzeichnet, daß der Container (55) eine Vordertür (4a) für die Bedienung des Rechners (2) und eine Hintertür (4b) für die Durchführung von Wartungs- und Reparaturarbeiten aufweist und daß die Montagewand (5) eine Seitenwand des Containers (55) bildet.

13. Sicherheitseinrichtung nach einem der Ansprüche 1 bis 12, dadurch gekennzeichnet, daß der Sicherheitscontainer (1, 55) mit elektronischen Überwachungseinrichtungen wie Alarmdrahtmatten als Außenhautüberwachung und/oder Körperschallmeldern ausgerüstet ist.

14. Sicherheitseinrichtung nach einem der Ansprüche 1 bis 13, gekennzeichnet durch eine in den Container (1, 55) eingebaute automatische Löschanlage.

15. Sicherheitseinrichtung nach einem der Ansprüche 1 bis 14, gekennzeichnet durch einen am Außenmantel (8) des Containergehäuses (3) angebrachten Wassermelder (56).

16. Sicherheitseinrichtung nach einem der Ansprüche 1 bis 11 und 13 bis 15, dadurch gekennzeichnet, daß zwischen Containergehäuse (3) und Montagewand (5) ein Erweiterungsbauteil (60) zum Vergrößern der inneren Tiefe des Containers (1) angeordnet ist.

17. Sicherungseinrichtung nach Anspruch 16, dadurch gekennzeichnet, daß das Erweiterungsbauteil (60) durch ein Außengehäuse (61) mit einem Außenmantel (62) aus Stahlblech und einem Schichtaufbau (63) aus einem Wärmedämmaterial oder verschiedenen Dämmaterialien und durch ein Innengehäuse (64) mit einem Innenmantel (65) aus Stahlblech und einer oder mehreren Schichten (66) aus wärmeabsorbierendem Material gebildet ist.

18. Sicherheitseinrichtung nach Anspruch 17, dadurch gekennzeichnet, daß Außen- (61) und Innengehäuse (64) des Erweiterungsbauteils (60) durch einen Zwischenraum (67) getrennt sind.

19. Sicherheitseinrichtung nach einem der Ansprüche 16 bis 18, dadurch gekennzeichnet, daß das Erweiterungsbauteil (60) durch die Außen- (33) und die Innenverschraubung (34) mit dem Containergehäuse (3) verbunden ist, wobei das Erweiterungsbauteil (60) durch die feuersicheren Hochtemperaturdichtungen (35) und bei erhöhten Temperaturen expandierenden Dichtungen (36) sowie gas- und wasserdichten Dichtungen (37), z.B. aus Gummi, gegenüber dem Containergehäuse (3) abgedichtet ist.

20. Sicherheitseinrichtung nach einem der Ansprüche 16 bis 19, dadurch gekennzeichnet, daß die Montagewand (5) durch die Außen- (33) und die Innenverschraubung (34) mit dem Erweiterungsbauteil (60) verbunden ist, wobei die Montagewand (5) durch die feuersicheren Hochtemperaturdichtungen (35) und bei erhöhten Temperaturen expandierenden Dichtungen (36) sowie gas- und wasserdichten Dichtungen (37), z.B. aus Gummi, gegenüber dem Erweiterungsbauteil (60) abgedichtet ist.

## Claims

1. A security device for electronic data processing apparatus, with a container (1, 35) protected against external damaging factors such as fire, moisture, entry of water, flammable gases and magnetic fields and protected against breaking in, for reception of and for operation of an electronic computer (2) and with an air-conditioning unit (6), characterized in that the container (1, 55) consists of a multi-walled container housing (3) formed as a Faraday cage, with at least one door (4) and a mounting wall (5) for fitting operating devices for the computer (2), wherein the door (4) and mounting wall (5) are removable from the container housing (3) of the container (1, 55) for transport and setting up purposes, and in that the power and data cables required for the operation of the computer (2) as well as the coolant lines of the air-conditioning unit (6) are fed into the interior space of the container via mass memory cable bulkheads (52) which are fire resistant, watertight and resistant to pressure and arranged on the inside (38) and outside (45) of the mounting wall (5).

2. A security device according to claim 1, characterized in that the container housing (3) is formed by an outer housing (7) with an outer cladding (8) of sheet steel and a layer structure (9) of heat insulating material or several insulating materials and an inner housing (10) with an inner cladding (11) of sheet steel and one or more layers (12) of heat absorbing material.

3. A security device according to claim 2, characterized in that the outer housing (7) and inner housing (10) of the container housing (3) are separated by a space (13).

4. A security device according to any of claims 1 to 3, characterized in that the or each door (4) of the container (1, 55) consists of an outer housing (15) of sheet steel with surrounding fire and sealing rims (16) as well as a layer structure (17) of one or several heat insulating materials and an inner housing (18) formed as a sheet steel box with one or more layers (19) of heat absorbing material.

5. A security device according to claim 4, characterized by surrounding seals (20) in the door rim (16) which expand at elevated temperatures and a surrounding water and gas seal (23), as well as a surrounding high temperature seal (22) in the door frame (21) of the door (4).

6. A security device according to claims 4 and 5, characterized by a lock mechanism (26) with lock bolts (24) securing the door (4) on all four sides.

7. A security device according to any of claims 1 to 6, characterized in that the removable mounting wall (5) of the container (1, 55) comprises an outer housing (29) of steel sheet with a layer structure (30) of a heat insulating material or several heat insulating materials and an inner housing (31) formed as a sheet steel tray with a layer structure (32) of heat absorbing material, and in that the mounting wall (5) is connected to the container housing (3) by outer and inner screw fixings (33 and 34 respectively), wherein the mounting wall (5) is sealed relative to the container housing (3) by fire resistant high temperature seals (35) and seals (36) which expand at elevated temperatures, as well as gas and watertight seals, e.g. of rubber.

8. A security device according to claim 7, characterized in that there are fitted on the inside (38) of the mounting wall (5) a fan (39) and control part (40) of the air conditioning unit (6), a temperature sensor (41), a smoke and temperature alarm (42), a plug strip (43) and a wall lamp (44) and on the outside (45) of the mounting wall (5) a receiving frame (47) for the condenser (48) of the air conditioning unit (6) covered by a removable protective case (46), a condenser water tray (49), a module (59) for uninterruptable current supply for the computer (2) and an external temperature display (51).

9. A security device according to any of claims 1 to 8, characterized by pull-out shelves (54) built into the container (1, 55) for receiving the units of the computer (2).

10. A security device according to any of claims 1 to 9, characterized in that the air conditioning unit (6) is implemented as a security unit and consists of two independent unit parts cooperating with each other.

11. A security device according to any of claims 1 to 10, characterized in that the mounting wall (5) forms the rear wall of the container (1).

12. A security device according to any of claims 1 to 10, characterized in that the container (55) comprises a front door (4a) for operating the computer(2) and a rear door (4b) for carrying out servicing and repair work and in that the mounting wall (5) forms a side wall of the container (55).

13. A security device according to any of claims 1 to 12, characterized in that the security container (1, 55) is equipped with electronic monitoring devices, such as alarm wire mats for monitoring the outer shell and/or structure-borne sound warnings.

14. A security device according to any of claims 1 to 13, characterized by an automatic extinguishing unit fitted in the container (1, 55).

15. A security device according to any of claims 1 to 14, characterized by a water alarm (56) fitted on the outer cladding (8) of the container housing (3).

16. A security device according to any of claims 1 to 11 and 13 to 15, characterized in that an extension component (60) for enlarging the inner depth of the container (1) is fitted between the container housing (3) and the mounting wall (5).

17. A security device according to claim 16, characterized in that the extension component (60) is formed by an outer housing (61) with an outer cladding (62) of sheet steel and a layer structure (63) of a heat insulating material or several insulating materials and an inner housing (64) with an inner cladding (65) of sheet steel and one or more layers (66) of heat absorbing material.

18. A security device according to claim 17, characterized in that the outer and inner housings (61 and 64 respectively) of the extension component (60) are separated by a space (67).

19. A security device according to any of claims 16 to 18, characterized in that the extension component (60) is connected to the container housing (3) by the outer and inner screw fixings (33 and 34 respectively), wherein the extension component (60) is sealed relative to the container housing (3) by the fire resistant high temperature seals (35) and seals (36) expanding at elevated temperatures as well as gas and watertight seals (37), e.g. of rubber.

20. A security device according to any of claims 1 6 to 19, characterized in that the mounting wall (5) is connected to the extension component (60) by the inner and outer screw fixings (33 and 34 respectively), wherein the mounting wall (5) is sealed relative to the expansion unit (60) by the fire resistant high temperature seals (35) and seals (36) expanding at elevated temperatures, as well as gas and watertight seals (37), e.g. of rubber.

## Revendications

1. Dispositif de sécurité pour des installations de traitement de données, comportant un conteneur (1, 55) protégé des influences extérieures d'incidents, comme du feu, de l'humidité, de l'inondation, des gaz d'incendie et des champs magnétiques et à l'épreuve de l'effraction, servant à recevoir et à faire fonctionner un ordinateur (2) électronique et comportant une installation (6) de conditionnement d'air, caractérisé en ce que le conteneur (1, 55) est constitué d'une caisse (3) de conteneur à plusieurs parois, réalisée en cage de Faraday, comportant au moins une porte (4) et une paroi (5) de montage pour le montage de dispositifs servant à faire fonctionner l'ordinateur (2), la porte (4) et la paroi (5) de montage étant amovibles à des fins de transport et d'installation de la caisse (3) du conteneur (1, 55), et en ce que les câbles de puissance et de transmission de données nécessaires au fonctionnement de l'ordinateur (2) ainsi que les lignes de fluide frigorigène de l'installation (6) de conditionnement d'air sont introduites à l'intérieur du conteneur par l'intermédiaire de cloisons (52) étanches pour câbles à accumulation de masse à l'épreuve du feu, étanches à l'eau et résistantes à la pression, montées sur la face (38) intérieure et sur la face (45) extérieure de la paroi (5) de montage.

2. Dispositif de sécurité suivant la revendication 1, caractérisé en ce que la caisse (3) du conteneur est formée par une caisse (7) extérieure, comportant une surface (8) latérale extérieure en tôle d'acier et une structure (9) stratifiée en un matériau calorifuge ou en divers matériaux isolants, et par une caisse (10) intérieure, comportant une surface (11) latérale intérieure en tôle d'acier et une couche (12) ou plusieurs couches (12) en un matériau absorbant la chaleur.

3. Dispositif de sécurité suivant la revendication 2, caractérisé en ce la caisse (7) extérieure et la caisse (10) intérieure de la caisse (3) de conteneur sont séparées par un interstice (13).

4. Dispositif de sécurité suivant l'une des revendications 1 à 3, caractérisé en ce la porte (4) ou chaque porte (4) du conteneur (1, 55) est constituée par une caisse (15) extérieure en tôle d'acier, comportant des rainures (16) à l'épreuve du feu et d'étanchéité faisant tout le tour ainsi qu'une structure (17) stratifiée en un matériau calorifuge ou en divers matériaux calorifuges, et par une caisse (18) intérieure réalisée en cassette en tôles d'acier, comportant une couche (19) ou plusieurs couches (19) en un matériau absorbant la chaleur.

5. Dispositif de sécurité suivant la revendication 4, caractérisé par des garnitures (20) d'étanchéité situées dans la rainure (16) de la porte, faisant tout le tour et s'expansant à des températures élevées, et par une garniture (23) d'étanchéité à l'eau et aux gaz faisant tout le tour, ainsi que par une garniture (22) d'étanchéité résistant aux hautes températures, faisant tout le tour, ménagée dans l'huisserie (21) de la porte (4).

6. Dispositif de sécurité suivant la revendication 4 et 5, caractérisé par un système (26) de verrouillage comportant des tiges (24) de verrouillage bloquant la porte des quatre côtés.

7. Dispositif de sécurité suivant l'une des revendications 1 à 6, caractérisé en ce la paroi (5) de montage amovible du conteneur (1, 55) comporte une caisse (29) extérieure en tôle d'acier, comportant une structure (30) stratifiée en un matériau calorifuge ou en divers matériaux calorifuges, et une caisse (31) intérieure, réalisée en cuve en tôles d'acier et comportant une structure (32) stratifiée en matériau absorbant la chaleur, et en ce que la paroi (5) de montage est reliée à la caisse (3) du conteneur par un vissage (33) extérieur et par un vissage (34) intérieur, la paroi (5) de montage étant rendue étanche par rapport à la caisse (3) du conteneur par des garnitures (35) d'étanchéité à l'épreuve du feu, résistant aux températures, et par des garnitures (36) d'étanchéité s'expansant à de hautes températures, ainsi que par des garnitures (37) d'étanchéité étanches aux gaz et étanches à l'eau, qui sont par exemple en caoutchouc.

8. Dispositif de sécurité suivant la revendication 7, caractérisé en ce qu'il est monté sur la face (38) intérieure de la paroi (5) de montage un ventilateur (39) et une pièce (40) pour faire fonctionner l'installation (6) de conditionnement d'air, un capteur (41) de température, un avertisseur (42) de fumée et de température, une baguette (43) de connexion et une lampe (44) murale et en ce qu'il est monté sur la face (45) extérieure de la paroi (5) de montage un support (47) de réception du condenseur (48) de l'installation (6) de conditionnement d'air qui est recouvert par une boite (46) de protection amovible, une cuve (49) pour de l'eau de condensation, un groupe (59) servant à l'alimentation en courant sans interruption de l'ordinateur (2) et un indicateur (51) extérieur de température.

9. Dispositif de sécurité suivant l'une des revendications 1 à 8, caractérisé par des plateaux (54) amovibles montés dans le conteneur (1, 55) et servant à recevoir les unités de l'ordinateur (2).

10. Dispositif de sécurité suivant l'une des revendications 1 à 9, caractérisé en ce que l'installation (6) de conditionnement d'air est réalisée en installation de sécurité et est constituée de deux parties d'installation autonomes qui coopèrent.

11. Dispositif de sécurité suivant l'une des revendications 1 à 10, caractérisé en ce la paroi (5) de montage forme la paroi arrière du conteneur (1).

12. Dispositif de sécurité suivant l'une des revendications 1 à 10, caractérisé en ce que le conteneur (55) comporte une porte (4a) avant pour utiliser l'ordinateur (2) et une porte (4b) arrière pour effectuer des travaux d'entretien et de réparation. et en ce que la paroi (5) de montage forme une paroi latérale du conteneur (55).

13. Dispositif de sécurité suivant l'une des revendications 1 à 12, caractérisé en ce le conteneur (1, 55) de sécurité est muni de dispositifs de surveillance électronique comme des paillassons à fils métalliques d'alerte servant de dispositifs de surveillance par membrane extérieure et/ou de détecteurs sismiques.

14. Dispositif de sécurité suivant l'une des revendications 1 à 13, caractérisé par une installation automatique pour éteindre les incendies montée dans le conteneur (1, 55).

15. Dispositif de sécurité suivant l'une des revendications 1 à 14, caractérisé par un détecteur d'eau monté sur la surface (8) latérale extérieure de la caisse (3) de conteneur.

16. Dispositif de sécurité suivant l'une des revendications 1 à 11 et 13 à 15, caractérisé en ce qu'il est monté entre la caisse (3) du conteneur et la paroi (5) de montage une pièce (60) d'élargissement pour augmenter la profondeur intérieure du conteneur (1).

17. Dispositif de sécurité suivant la revendication 16, caractérisé en ce la pièce (60) d'élargissement est formée par une caisse (61) extérieure, comportant une surface (62) latérale extérieure en tôle d'acier et une structure (63) stratifiée en un matériau calorifuge ou en divers matériaux isolants, et par une caisse (64) intérieure, comportant une surface (65) latérale intérieure en tôle d'acier et une couche (66) ou plusieurs couches (66) en matériau absorbant la chaleur.

18. Dispositif de sécurité suivant la revendication 17, caractérisé en ce la caisse (61) extérieure et la caisse (64) intérieure de la pièce (60) d'élargissement sont séparées par un interstice (67).

19. Dispositif de sécurité suivant l'une des revendications 16 à 18, caractérisé en ce la pièce (60) d'élargissement est reliée à la caisse (3) du conteneur par le vissage (33) extérieur et par le vissage (34) intérieur, la pièce (60) d'élargissement étant rendue étanche par rapport à la caisse (3) du conteneur par les garnitures (35) d'étanchéité à l'épreuve du feu, résistant à de hautes températures, et des garnitures (36) d'étanchéité s'expansant à de hautes températures, ainsi que par des garnitures (37) d'étanchéité étanches aux gaz et étanches à l'eau, qui sont par exemple en caoutchouc.

20. Dispositif de sécurité suivant l'une des revendications 16 à 19, caractérisé en ce la paroi (5) de montage est reliée à la pièce (60) d'élargissement par le vissage (33) extérieur et par le vissage (34) intérieur, la paroi (5) de montage étant rendue étanche par rapport à la pièce (60) d'élargissement par les garnitures (35) d'étanchéité à l'épreuve du feu, résistant à de hautes températures, et par des garnitures (36) d'étanchéité s'expansant à des températures élevées, ainsi que par des garnitures (37) d'étanchéité étanches aux gaz et étanches à l'eau, qui sont par exemple en caoutchouc.
